Europäisches Patentamt

European Patent Office

Office européen des brevets

(19)

(11) Veröffentlichungsnummer: **0 254 061**

**A2**

(12) **EUROPÄISCHE PATENTANMELDUNG**

(21) Anmeldenummer: **87109100.5**

(22) Anmeldetag: **24.06.87**

(51) Int. Cl.⁴: **H03D 3/24** , H04L 27/22 ,
G08G 1/09

(30) Priorität: **19.07.86 DE 3624529**

(43) Veröffentlichungstag der Anmeldung:
**27.01.88 Patentblatt 88/04**

(84) Benannte Vertragsstaaten:
**AT CH DE ES FR GB IT LI SE**

(71) Anmelder: **Blaupunkt-Werke GmbH
Robert-Bosch-Strasse 200
D-3200 Hildesheim(DE)**

(72) Erfinder: **Hegeler, Wilhelm
Grosse Venedig 23
D-3200 Hildesheim(DE)**

(74) Vertreter: **Eilers, Norbert, Dipl.-Phys.
Blaupunkt-Werke GmbH
Robert-Bosch-Strasse 200
D-3200 Hildesheim(DE)**

(54) **Digitaler Demodulator.**

(57) Digitaler Demodulator für die ARI-und RDS-
Demodulation, der im Falle ARI = 0 (kein 57 kHz-
Träger) in der Phase auf RDS einrasten kann, und
der im Falle ARI = 1 auf ARI einrasten kann. In
beiden Fällen entsteht das RDS-Signal jeweils an
derselben Ausgangsklemme.

FIG. 3

EP 0 254 061 A2

## Digitaler Demodulator

Die Erfindung betrifft einen digitalen Demodulator gemäß dem Oberbegriff des Anspruchs 1.

Demodulatoren dieser Gattung werden insbesondere für Autoradios mit einer Verkehrsrundfunk (VR)-Kennung benötigt, bei welchen zusätzlich sogenannte RDS (Radio-Data-System)-Informationen dekodiert werden.

Bekanntlich ist es schon seit längerer Zeit üolich, dem Autofahrer zur Verbesserung des Verkehrsablaufes und zur Erhöhung der Verkehrssicherheit über bestimmte Rundfunksender (Verkehrsfunksender) Verkehrshinweise zu geben. Um dem Autofahrer das Aufsuchen des für seinen örtlichen Bereich zuständi gen Verkehrsfunksenders zu erleichtern, wird das Kennungssystem ARI (eingetragenes Warenzeichen; Autofahrer-Rundfunk-Information) eingesetzt, welches bekanntlich drei Kennfrequenzen verwendet, die im UKW-Bereich zusätzlich zur Nutzmodulation des FM-Verkehrsfunksenders aufmoduliert werden. Für die Senderkennung ist dabei ein 57 kHz-Träger vorgesehen, der zur Kennzeichnung aller Verkehrsfunksender dient.

Daneben ist zusätzlich auch das sogenannte RDS-System bekannt geworden ("Specification of the radio data system RDS", Sonderdruck der EBU technical centre, Brüssel, Tech. 3244 E, März 1984), welches die Übertragung von Informationen ermöglicht, die beispielsweise die Art des jeweiligen Programmes (Programmtyp), eine Senderidentifikation, alternative Sendefrequenzen usw. betreffen.

Bei dem RDS-System erfolgt die Übertragung der RDS-Informationen in Form von digitalen Signalen auf einem unterträger von 57 kHz über UKW-Rundfunksender, wobei eine Zweiseitenbandamplitudenmodulation des 57 kHz-Trägers (Träger wird unterdrückt; mit dem biphase-codierten Datensignal erfolgt. Durch die Biphase-Codierung erscheinen in der Nähe des Trägers keine Spektrallinien, so daß eine Kompatibilität mit dem ARI-System gegeben ist.

Daher besteht grundsätzlich in vorteilhafter Weise die Möglichkeit, sowohl ARI-Signale und/oder RDS-Signale zu übertragen, und empfängerseitig stellt sich dann die Forderung nach einem Demodulator, der die Rückgewinnung der gesendeten aufmodulierten ARI-Signale und RDS-Signale gewährleistet. Zu diesem Zweck wird der digitale Demodulator gemäß dem Oberbegriff des Anspruchs 1 verwendet.

Beim Einsatz eines digitalen Demodulators nach dem PLL-Prinzip läßt sich die obige Forderung in der Praxis aber nicht erfüllen. Der PLL-Demodulator kann nämlich nur für den Fall ARI = 1 einrasten, wenn also der 57 kHz-Träger vorhanden ist. Im Fall ARI = 0, wenn kein Träger vorhanden ist, läßt sich ein RDS-Signal nicht demodulieren. Das bedeutet, daß mit dem PLL-Demodulator RDS-Signale nur gewonnen werden können, wenn der 57 kHz-Träger vorhanden ist (ARI = 1).

Mit einem weiter unten anhand der Zeichnung noch näher beschriebenen Demodulator nach dem sogenannten "Costas Loop-Prinzip" ist es demgegenüber zwar grundsätzlich möglich, auch im Falle ARI = 0 ein RDS-Signal zu demodulieren und zu erhalten, allerdings besteht dabei der Nachteil, daß das RDS-Signal - in Abhängigkeit der Möglichkeiten ARI = 0 oder ARI = 1 - an unterschiedlichen Ausgangsklemmen abgegriffen werden muß.

An einer ersten Ausgansklemme erscheint das RDS-Signal für den Fall ARI = 0, während an dieser Klemme für den Fall ARI = 1 das ARI-Signal abgegriffen werden kann. An einer zweiten Ausgangsklemme steht das RDS-Signal nur dann zur Verfügung, wenn der 57 kHz-Träger vorhanden ist (ARI = 1).

Da die RDS-Signale in Abhängigkeit von dem Vorhandensein des 57 kHz-Trägers an unterschiedlichen Ausgangsklemmen auftreten, läßt sich diese Costas-Loop-Schaltung in der Praxis nicht einsetzen. Es wäre nämlich ein erheblicher zusätzlicher elektronischer Schaltungsaufwand erforderlich, um unbahängig für die Fälle ARI = 0 und ARI = 1 zu gewährleisten, daß das RDS-Signal immer an einer gleichen Ausgangsklemme zur Verfügung steht.

Hier greift nun die Erfindung ein, der die Aufgabe zugrunde liegt, einen digitalen Demodulator für die ARI-und RDS-Demodulation zu schaffen, der auch im Falle ARI = 0 - wenn also kein 57 kHz-Träger vorhanden ist - in der Phase auf RDS einrasten kann, und der gleichzeitig auch im Falle ARI = 1 auf ARI einrasten kann, wobei in beiden Fällen das RDS-Signal jeweils an derselben Ausgangsklemme zur Verfügung steht.

Dieses Ziel erreicht die Erfindung bei dem im Oberbegriff des Anspruchs vorausgesetzten Demodulator durch die im kennzeichnenden Teil des Anspruchs 1 angegebenen Merkmale.

Die Erfindung kombiniert mit einfachen Maßnahmen die PLL-Schaltung mit einer Costas-Loop-Schaltung mit dem Vorteil, daß der Demodulator sowohl im Falle ARI = 0 und ARI = 1 stabil einrasten kann, und daß in beiden Fällen das RDS-Signal jeweils an derselben Ausgangsklemme entsteht.

Der grundlegende Gedanke der Erfindung besteht darin, die Steuersignale für den spannungsgesteuerten Oszillator in geeigneter Weise zu bewerten und danach zu addieren. Dadurch bleiben die gewünschten Eigenschaften sowohl der PLL-Schaltung als auch der Costas-Loop-Schaltung jeweils erhalten, und zwar mit der Maßnahme, daß das RDS-Signal in gewünschter Weise immer an derselben Ausgangsklemme auftritt.

Wie weiter unten anhand der Zeichnung noch näher erläutert wird, soll für den Fall ARI = 1 die PLL-Funktion dominieren. Damit ist festgelegt, an welchen Ausgängen die ARI-Signale und die RDS-Signale auftreten sollen. Das Dominieren wird durch einen Bewertungsfaktor erreicht, der größer als "1" ist.

Für den Fall ARI = 0 soll das RDS-Signal an dergleichen Ausgangsklemme erscheinen, wie bei ARI = 1. Dies wird in zweckmäßiger Weise durch eine geeignete Invertierung der Steuersignale erreicht, die bei der Costas-Loop-Schaltung auftreten. Durch die Invertierung der Steuersignale für den spannungsgesteuerten Oszillator bei der Costas-Loop-Schal tung werden nämlich die Rollen der vorhandenen Ausgänge vertauscht (90°-Drehung).

Die voranstehend erwähnte Dominanz der PLL-Funktion wird bei ARI = 0 (bzw. bei schwachem Träger) dadurch aufgehoben, daß an dem RDS-Ausgang im Mittel (über eine RDS-Periode) keine wesentliche Steuerinformation als Steuersignal für den spannungsgesteuerten Oszillator entsteht.

Zweckmäßige Ausgestaltungen und vorteilhafte Weiterbildungen der Erfindung sind in den Unteransprüchen angegeben und der Zeichnung zu entnehmen.

Nachfolgend wird die Erfindung anhand des in der Zeichnung dargestellten Ausführungsbeispiels näher erläutert. Es zeigen:

Fig. 1 einen Demodulator in PLL-Schaltung,

Fig. 2 einen Demodulator in Costas-Loop-Schaltung,

Fig. 3 ein erstes Ausführungsbei spiel eines Demodulators, bei welchem das RDS-Signal jeweils an dergleichen Ausgangsklemme auftritt,

Fig. 4 ein zweites Ausführungsbeispiel eines Demodulators, bei welchem das RDS-Signal jeweils an dergleichen Ausgangsklemme auftritt,

Fig. 5 ein mehr detailliertes Schaltbild eines Teiles des Demodulators gemäß Fig. 4, und

Fig. 6 - 9 jeweils Diagramme zur Erläuterung der Wirkungsweise der Demodulatoren gemäß Fig. 3 und 4.

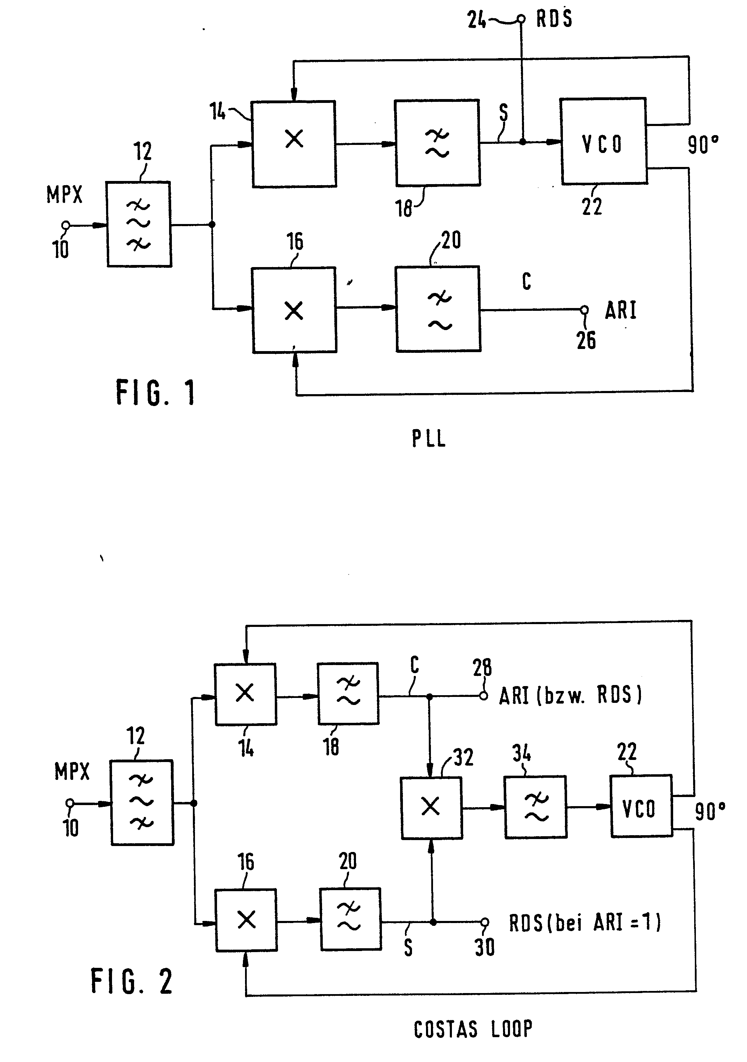

Zum besseren Verständnis der Erfindung werden nachfolgend zunächst anhand von Fig. 1 und 2 ein PLL-Demodulator und ein Costas-Loop-Demodulator beschrieben, wobei darauf hinzuweisen ist, daß diese Schaltungen das durch die Erfindung erreichte Ergebnis nicht er füllen können.

Dem PLL-Demodulator gemäß Fig. 1 wird über eine Eingangsklemme 10 das an sich bekannte MPX-Signal zugeführt, welches das aufmodulierte ARI-Signal und/oder das aufmodulierte RDS-Signal enthalten kann. Durch einen Bandpaß 12 (57 kHz-Filter) wird der Frequenzbereich um 57 kHz herausgefiltert.

Auf den Bandpaß 12 folgen jeweils zwei Mischer 14 und 16, an die sich jeweils Tiefpässe 18 und 20 anschließen. Der obere Tiefpaß 18 ist mit einem spannungsgesteuerten Oszillator 22 verbunden, der zwei in der Phase um 90° verschobene Hilfssignale erzeugt. Diese Hilfssignale werden dem Mischer 14 bzw. dem Mischer 16 zugeführt.

Am Ausgang des oberen Tiefpasses 18 kann an der Ausgangskleme 24 ein RDS-Signal abgegriffen werden, und am Ausgang des unteren Tiefpasses 20 steht an der Ausgangsklemme 26 das ARI-Signal zur Verfügung.

Der soweit beschriebene PLL-Demodulator kann nur auf ein trägerbehaftetes Signal einrasten. Daher ist es nur für den Fall ARI = 1 möglich, ein RDS-Signal zu erhalten. Bei ARI = 0 versagt diese Schaltung.

Fig. 2 zeigt eine sogenannte Costas-Loop-Schaltung. Bekanntlich sind Costas-Loop-Schaltungen für die Demodulation von trägerlosen Signalen geeignet. Das Prinzip besteht darin, nach einer 90°-Phasendrehung die Signale aus zwei Kanälen wieder zu mischen (Costas-Loop-Mischer) und mit dem multiplikativ gewonnenen Ausgangssignal nach einer Tiefpaßfilterung einen spannungsgesteuerten Oszillator anzusteuern.

In Fig. 2 umfaßt daher die Costas-Loop-Schaltung neben den beiden Mischern 14 und 16 und den Tiefpässen 18 und 20 eine Mischstufe 32 (Costas-Loop-Mischer), welchem um 90° phasenverschobene Signale zur multiplikativen Verknüpfung zugeführt werden. Das Ausgangssignal der Mischstufe 32 gelangt über einen Tiefpaß 34 zu dem Oszillator 22.

Ebenso wie in Fig. 1 entstehen auch in Fig. 2 wegen der 90° Phasenverschiebung an den Ausgängen der Tiefpässe 18 und 20 Ausgangssignale mit Sinus-und Cosinuskomponenten, die als Steuersignale S und C für den Oszillator 22 weiterverarbeitet werden.

Bei der Costas-Loop-Schaltung gemäß Fig. 2 läßt sich an der Ausgangsklemme 28 ein ARI-Signal abgreifen, und an der gleichen Ausgangsklemme 28 kann ein RDS-Signal entnommen werden, wenn ARI = 0 ist. An der unteren Ausgangsklemme 30 tritt das RDS-Signal bei ARI = 1 auf. Das bedeutet mit anderen Worten, daß das RDS-Signal einmal an der Ausgangsklemme 28 und einmal an der Ausgangsklemme 30 erscheint, je nach dem ob ARI = 0 oder ARI = 1 ist. Dies ist darauf zurückzuführen, daß aufgrund der vorgegebenen Normung und Realisierung das RDS-Signal bekanntlich um 90° in der Phase gegenüber dem ARI-Träger verschoben ist.

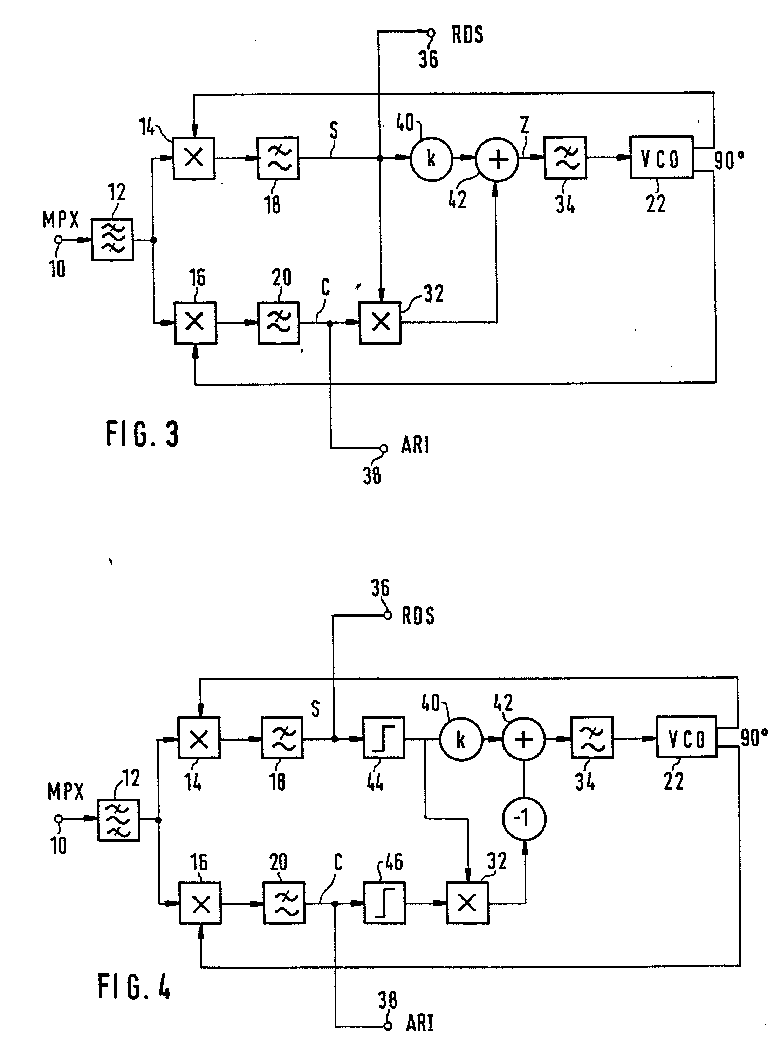

Fig. 3 zeigt nun ein Ausführungsbeispiel eines neuen digitalen Demodulators, der im Falle ARI = 0 auf RDS in der Phase einrasten kann, und der im Falle ARI = 1 auf ARI einrasten kann. In beiden Fällen steht dabei das RDS-Signal jeweils an derselben Ausgangsklemme 36 (das RDS-Signal "wechselt" also nicht die Ausgangsklemme).

Von der Eingangsklemme 10 gelangen die MPX-Signale über den Bandpaß 12 jeweils zu den Mischern 14 bzw. 16, denen von dem Oszillator 22 um 90° phasenverschobene Hilfssignale zugeführt werden. An den Ausgängen der beiden Tiefpässe 18 und 20 entstehen die in Sinus-und Cosinuskomponenten aufgeteilten Steuersignale S und C.

Das zweite Steuersignal S am Ausgang des Tiefpasses 18 wird nun einer Bewertungsschaltung 40 zugeführt, um das Signal mit einem Faktor k zu bewerten. Der Faktor besitzt hier den Wert "2", d.h. das Steuersignal S wird in seiner Amplitude verdoppelt. Dadurch wird eine Dominanz des Steuersignals S gegenüber dem anderen Steuersignal C erreicht.

An den Ausgang des anderen Tiefpasses 20 - schließt sich die Mischstufe 32 (Costas-Mischer) an, der die beiden Steuersignale S und C multiplikativ ver knüpft. Das Mischprodukt wird zu einer Addierstufe 42 geführt, wo es - nach Negierung - mit dem bewerteten Steuersignal S addiert wird. Das Ausgangssignal der Addierstufe 42 bildet nach Filterung durch den Tiefpaß 34 das Steuersignal für den Oszillator 22.

Die soweit beschriebene Schaltungsanordnung gemäß Fig. 3 kombiniert in geschickter Weise die Eigenschaften der weiter oben erläuterten PLL-Schaltung und der Costas-Loop-Schaltung zu einem digitalen Demodulator, bei welchem das RDS-Signal immer an dergleichen Ausgangsklemme 36 entsteht, während das ARI-Signal an der Ausgangsklemme 38 abgegriffen werden kann.

Die Kombination besteht darin, daß die Steuersignale für den Oszillator 22, wie sie in Fig. 1 und 2 auftreten, in vorteilhafter und geeigneter Weise bewertet und addiert werden, und zwar derart, daß die jeweils gewünschten Eigenschaften der PLL-Schaltung und Costas-Loop-Schaltung erhalten bleiben.

Einen Ausgangspunkt bildet die Überlegung, daß die PLL-Funktion dominieren soll, wenn ARI = 1 ist. Damit ist festgelegt, an welchen Ausgangsklemmen ARI-Signale und RDS-Signale erscheinen sollen. Das Dominieren der PLL-Funtkion wird durch den Bewertungsfaktor k erreicht, der hier beispielsweise den Wert "2" besitzt.

Wenn ARI = 0 ist, soll das RDS-Signal an dergleichen Ausgangsklemme erscheinen, und dies wird durch eine geeignete Invertierung der Steuersignale der Costas-Loop-Schaltung erreicht. In der Costas-Loop-Funtkion werden durch Invertierung der Steuersignale für den Oszillator nämlich die Bedeutungen der Ausgangsklemmen vertauscht (90°-Drehung).

Die oben angesprochene Dominanz der PLL-Funtkion wird bei ARI = 0 - bzw. bei schwachem 57 kHz-Träger - dadurch aufgehoben, daß an der Ausgangsklemme für das RDS-Signal im Mittel (über eine RDS-Periode) keine wesentliche Steuerinformation für den spannungsgesteuerten Oszillator 22 entsteht.

Zur Verdeutlichung und zum besseren Verständnis der Erfindung werden nachfolgend die im einzelnen auftretenden Signale näher erläutert. Das Eingangssignal nach dem Bandpaß 12 läßt sich wie folgt darstellen:

$$A \bullet \cos(\omega t + p) + R \sin(\omega t + p) \qquad (1)$$

mit folgenden Bedeutungen: A = ARI-Pegel, positiv $(1 + 0,6 \cos(\omega_{BK}\bullet t) + 0,3 \cos(\omega_{DK}\bullet t)$; die ersten beiden Glieder in dem voranstehenden Ausdruck stellen die Bereichskennung BK dar, und das dritte Glied kennzeichnet die Durchsagekennung DK. A kann während einer RDS-Periode als konstant gelten. Der Buchstabe R kennzeichnet die RDS-Amplitude $= 0,3 \sin(\omega_{RDS} \bullet t)$. Ferner bedeuten:

$(\omega = 2\pi \bullet 57$ kHz; t = Zeit;

$\omega_{RDS} 2 \bullet \pi \bullet = 1,1875$ kHz,
p = 57 kHz-Phasenfehler gegenüber einem - schaltungsinternen 57 kHz-Signal. Die Schaltungen seien in der Phase eingerastet, wenn die folgenden Bedingungen erfüllt sind:

p mod $2\pi$ = 0    (ARI = 1)
p mod $\pi$ = 0    (ARI = 0)

In den Mischern 14 und 16 werden die Eingangssignale mit den Hilfssignalen cos ($\omega$ t) und sin ($\pi$ t) des Oszillators 22 bzw. mit den entsprechenden Rechtecksignalen gemischt. Nach der Filterung durch die Tiefpässe 18 bzw. 20 ergeben sich als Mischprodukte die Steuersignale

$$C = A \bullet \cos p + R \bullet \sin p \quad (2)$$
$$S = -A \bullet \sin p + R \bullet \cos p \quad (3)$$

Diese Gleichungen (2) und (3) gelten für alle Demodulatoren gemäß Fig. 1 - 5, wobei die R-Komponente wegen der Beziehung $\omega_{RDS} = 2\pi \bullet 1.1875$ kHz schon abgeschwächt sein kann (wegen der relativ hohen Frequenzwerte).

In der PLL-Schaltung gemäß Fig. 1 ist das Steuersignal S im Mittel (über eine RDS-Periode gemittelt) = -A sin p, und das Einrasten erfolgt stabil bei p = 0, bei entsprechend geeigneter Kennlinie des spannungsgesteuerten Oszillators 22. Der Phasenfehler p wird als konstant während der Mittelung betrachtet.

Für die nachfolgende Betrachtung wird zum stabilen Einrasten der Schaltungen ein Nulldurchgang der Steuergröße mit einer negativen Steigung als erforderlich vorausgesetzt. Wie Fig. 2 zeigt, wird bei der Costas-Loop-Schaltung der Mittelwert des Produktes der Steuersignale C und S zur Phasensteuerung herangezogen:

$$C \bullet S = (R^2 - A^2) \sin p \bullet \cos p + A \bullet R (\cos^2 p - \sin^2 p)$$
$$= (R^2 - A^2) \bullet 0,5 \sin 2p + A \bullet R \bullet \cos 2p)$$

Nach Mittelung über eine RDS-Periode verschwindet der Bestandteil A $\bullet$ R $\bullet$ cos2p, weil R im Mittel gleich Null ist.

Für den Fall ARI = 1; ( $\overline{A^2} > \overline{R^2}$ ) ist eine Auslegung in dem Sinne möglich, daß die Demodulatoren bei p = 0 oder bei p = $\pi$ stabil einrasten. Der Klammerausdruck ($R^2 - A^2$) wird dann nämlich negativ. Für ARI = 0 ($A^2 = 0$; $\overline{R^2} \neq 0$ ist dann die Steuergröße für den Oszillator 22 invertiert, was zu einer stabilen Phase p = ± $\pi/2$ führt. Das RDS-Signal tritt in der Costas-Loop-Schaltung gemäß Fig. 2 an der Ausgangsklemme 28 auf, während es im Falle ARI = 1 an der Ausgangsklemme 30 erscheint.

Ein möglicher RDS-Demodulator, der nach diesem Prinzip arbeiten soll, müßte zur Vermeidung der Mehrdeutigkeit entweder das ARI-Signal unterdrücken, was wegen der Stärke der Modulation aber nur unvollkommen gelingt, oder es müßte mit Hilfe einer ARI-Erkennung die Quelle für die RDS-DEmodulation jeweils in geeigneter Weise umgeschaltet werden, was aber zu Verzögerungen und Fehlern führen kann. Daher ist die Costas-Loop-Schaltung im vorliegenden Fall nicht geeignet.

Erst die Kombination der PLL-Schaltung mit der Costas-Loop-Schaltung ermöglicht mit einfachen Mitteln ein stabiles Einrasten und das Abgreifen des RDS-Signals an dergleichen Ausgangsklemme. Dabei wird das Steuersignal der PLL-Schaltung mit einem Faktor k bewertet (k $\bullet$ A $\bullet$ sinp), und das Steuersignal der Costas-Loop-Schaltung wird dazu mit negativer Bewertung addiert.

Von besonderem Vorteil ist der digitale Demodulator gemäß Fig. 4, bei welchem die Steuersignale C und S durch die jeweiligen Signumfunktionen ersetzt werden. An die beiden Tiefpässe 18 und 20 schließt sich hier jeweils ein Begrenzer 44 bzw. 46 an. Auf den Begrenzer 46 folgt die oben - schon beschriebenen Mischstufe 32 (Costas-Mischer), dem noch die Ausgangssig nale des anderen Begrenzers 44 zur Mischung zugeführt sind. Im übrigen entspricht die Ausführungsform gemäß Fig. 4 der Schaltung in Fig. 3, d.h. die am Ausgang des Begrenzers 44 vorhandene Signumfunktion gelangt zur Bewertungsschaltung 40 und anschließend zu Addierstufe 42. Das Mischprodukt der Mischstufe 32 wird nach Invertierung ebenfalls der Addierstufe 42 zur Addition zugeführt, deren Ausgangssignal nach Filterung durch den Tiefpaß 34 den Oszillator 22 ansteuert.

Wenn die Steuersignale C und S durch die Signumfunktionen ersetzt werden, lautet die Steuergröße für den Oszillator 22:

$$Z = Sgn (S) \bullet (k - Sgn (C))$$

Für diesen Fall werden nachfolgend drei Möglichkeiten betrachtet: 1. ARI = 0, 2. RDS = 0 und 3. $R_{max} \neq 0$ mit A > $|R_{max}|$.

Im ersten Fall gelten die Randbedingungen A = 0, C = R $\bullet$ sinp, S = R $\bullet$ cosp und $R_{max} \neq 0$. Dann ergibt sich

$$Z = Sgn (R \bullet \cos p) \bullet (k - Sgn (R \bullet \sin p)),$$

wobei über eine RDS-Periode gemittelt $\Sigma$ Sgn (R $\bullet$ cosp) $\bullet$ k verschwindet.

$$Z = -Sgn (R \bullet \cos p) \, Sgn (R \bullet \sin p) = -Sgn (\sin 2p)$$

Das Einrasten erfolgt bei den Nullstellen mit negativer Steigung: p = 0 oder p = $\pi$.

Im zweiten Fall RDS = 0 mit den Bedingungen R = 0, C = A $\bullet$ cosp, S = -A $\bullet$ sinp und A $\neq$ 0 gilt:

$$Z = -k \bullet Sgn (\sin p) \bullet Sgn (\sin \bullet (2p))$$

Bei k > 1 gibt es nur einen Nulldurchgang mit negativer Steigung: p = 0. Wegen des Faktors k ist der erste Summand betragsmäßig größer als der zweite Summand, daher liegt hier für p = 0 eine Eindeutigkeit vor, was praktisch der normalen PLL-Funktion entspricht.

Für den dritten allgemeinen Fall gilt $R_{max} \neq 0$ und $A > |R_{max}|$ Für die Steuersignale gelten dann die Beziehungen

$$C = A\cos p + R \bullet \sin p = a \bullet \cos (p - e)$$
$$S = -A \bullet \sin p + R \bullet \cos p = -a \bullet \sin (p - e)$$

mit

$$a = \sqrt{A^2 + R^2}$$

und $e = \text{arctg } R/A$.

Das Signal Z erhält man gemäß den Gleichungen aus dem voranstehend beschriebenen Fall zwei, in dem p durch p - e ersetzt wird:

$$Z = -k \bullet \text{Sgn} (\sin (p - e)) + \text{Sgn} (\sin (2 (p - e))).$$

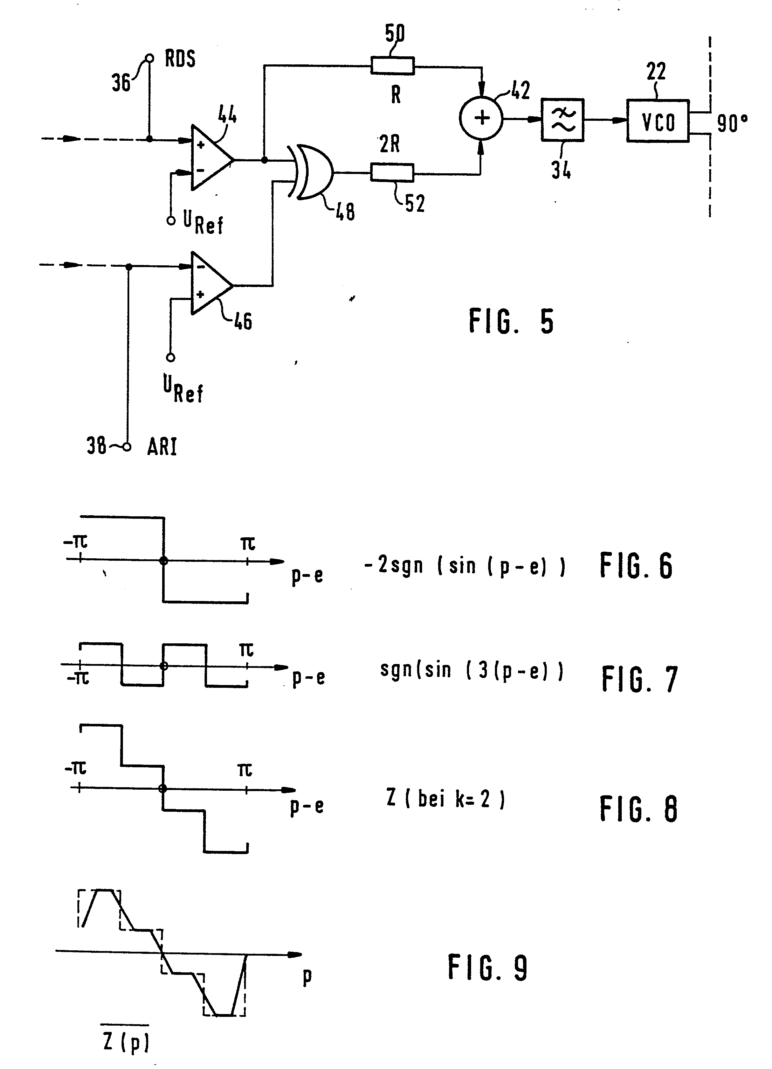

Die graphischen Darstellungen gemäß Fig. 6 - 9 verdeutlichen, daß die zeitliche Variation von $R = R_{max} \sin (\omega_{RDS} \bullet t)$ eine Schwingung von e um Null mit den Maximalwerten $\pm \text{arctg } R_{max}/A$ bewirkt, mit $|e| < \pi/4$. Die Schwingung von e rührt vom RDS-Signalanteil her (wenn RDS = 0 ist, gibt es keine e-Schwingung; e = 0).

Bei größeren Werten A (Normalfall) bleibt $|e|$ wesentlich kleiner. Fig. 6 zeigt aus der obigen Gleichung den ersten Summanden für k = 2, und Fig. 7 verdeutlicht den zweiten Summanden. Die Addition bzw. den Wert für Z kann man aus Fig. 8 entnehmen.

Der "Sprung" bzw. der Nulldurchgang wird mit kleineren Werten von k geringer und umgekehrt. Wenn k groß ist (vgl. Fig. 6) wird der zweite Summand praktisch ver nachlässigbar.

Gemäß der Darstellung in Fig. 9 wird die Treppenkurve für Z (p) an den Flanken bei der Mittelung über eine RDS-Periode zwar eine endliche Steigung aufweisen, sie bleibt aber momoton bei den Nullstellen und enthält keine zusätzlichen Nullstellen, so daß Mehrdeutigkeiten vermieden sind. Damit ist ein stabiles Einrasten bei p = 0 gewährleistet.

In Fig. 5 ist ein Teil des digitalen Demodulators gemäß Fig. 4 in mehr detaillierter Darstellung gezeigt, und es ist zu erkennen, daß die Mischstufe 32 durch ein EX/OR-Glied 48 gebildet wird. Die Begrenzer 44 und 46 sind jeweils mit einem Anschluß mit einer Referenzspannung $U_{Ref}$ verbunden.

Der Ausgang des Begrenzers 44 führt über einen Widerstand 50 mit dem Wert R zu der Addierstufe 52, während der Ausgang des EX/OR-Gliedes 48 über einen Widerstand 52 mit dem Wert 2R mit der Addierstufe 42 verbunden ist. Durch die beiden Widerstände 50, 52 erfolgt hier die Bewertung, wobei der Faktor k = 2 ist. Die genannte Invertierung des EX/OR-Ausgangssig nals ist durch eine geeignete Vertauschung der Eingänge des Begrenzers 46 erreicht.

Das Ausgangssignal der Addierstufe 42 gelangt zu dem weiter oben schon erwähnten Tiefpaß 34, dessen Ausgangssignal den Oszillator 22 ansteuert.

## Ansprüche

1. Digitaler Demodulator zur Demodulation von Eingangssignalen, die ein einen Träger enthaltendes erstes amplitudenmoduliertes Signal und/oder ein zweites amplitudenmoduliertes Signal mit unterdrücktem Träger aufweisen, wobei die beiden Träger frequenzgleich und um 90° gegeneinander phasenverschoben sind, mit Mischern, denen die Eingangssignale und je ein Hilfssignal eines spannungsgesteuerten Oszillators (VCO) zugeführt sind, und mit Tiefpässen, deren Ausgangssignale in Sinus-und Cosinuskomponenten getrennt sind und die als erste und zweite Steuersignale für die Ansteuerung des spannungsgesteuerten Oszillators über einen weite ren Tiefpaß herangezogen sind, dadurch gekennzeichnet, daß mindestens eines der beiden Steuersignale (C, S) eine digitale Mischstufe (32) durchläuft, daß mindestens eines der Steuersignale einer Bewertung (40) mit einem Faktor (k) unterzogen ist, (k $\neq$ 0), und daß die so verarbeiteten Steuersignale in einer Addierstufe (42) addiert werden.

2. Demodulator nach Anspruch 1, dadurch gekennzeichnet, daß das zweite Steuersignal (S) in seiner Amplitude um den genannten Faktor (k) beeinflußt wird, und daß das Signal am Ausgang der Mischstufe (32) einer Invertierung unterzogen wird.

3. Demodulator nach Anspruch 1 und/oder 2, dadurch gekennzeichnet, daß der Ausgang der Addierstufe (42) über den weiteren Tiefpaß (34) mit dem Eingang des spannungsgesteuerten Oszillators (22) verbunden ist.

4. Demodulator nach einem der vorhergehenden Ansprüche 1 - 3, dadurch gekennzeichnet, daß an den Ausgängen der Tiefpässe (18, 20) jeweils das Signum des ersten Steuersignals (C) und des zweiten Steuer signals (S) gebildet wird.

5. Demodulator nach einem der vorhergehenden Ansprüche 1 - 4, dadurch gekennzeichnet, daß die Mischstufe (32) durch ein EX/OR-Glied gebildet ist (Costas-Mischer).

6. Demodulator nach einem der vorhergehenden Ansprüche 1 - 5, dadurch gekennzeichnet, daß das im zweiten amplitudenmodulierten Signal enthaltene Modulationssignal ein RDS-Signal und das im ersten amplitudenmodulierten Signal enthaltene Modulationssignal ein ARI-Signal ist.

FIG. 1

PLL

FIG. 2

COSTAS LOOP

FIG. 3

FIG. 4

FIG. 5

$-2\,\mathrm{sgn}\,(\sin\,(p-e))$ **FIG. 6**

$\mathrm{sgn}(\sin\,(3(p-e))$ **FIG. 7**

$Z\,(\text{bei }k=2\,)$ **FIG. 8**

**FIG. 9**

$\overline{Z(p)}$